**Europäisches Patentamt**

**European Patent Office**

**Office européen des brevets**

(19)

(11) Numéro de publication: **0 113 264
B1**

(12) **FASCICULE DE BREVET EUROPÉEN**

(45) Date de publication du fascicule du brevet:
18.03.87

(51) Int. Cl.⁴: **H 03 L 1/00**

(21) Numéro de dépôt: **83402311.1**

(22) Date de dépôt: **01.12.83**

(54) Oscillateur haute fréquence à défaut d'isochronisme compensé.

(30) Priorité: 27.12.82 FR 8221797

(43) Date de publication de la demande:
11.07.84 Bulletin 84/28

(45) Mention de la délivrance du brevet:
18.03.87 Bulletin 87/12

(84) Etats contractants désignés:
CH GB IT LI NL SE

(56) Documents cité:
EP-A-0 023 171
FR-A-2 410 909
GB-A-824 786
US-A-3 826 931

(73) Titulaire: ETAT- FRANCAIS représenté par le
DELEGUE GENERAL POUR L'ARMEMENT,
Bureau des Brevets et Inventions de la
Délégation Générale pour l'Armement 14, rue
Saint- Dominique, F-75997 Paris Armées (FR)

(72) Inventeur: Valentin, Jean- Pascal, Rue des Vignes,
F-25115 Pouilley les vignes (FR)

## Description

La présente invention concerne un oscillateur haute fréquence du type comprenant, monté dans une enceinte étanche, un résonateur piézoélectrique associé à au moins deux électrodes excitatrices produisant un champ électrique dans la partie active du cristal piézoélectrique, des moyens pour appliquer aux électrodes d'une part une puissance électrique d'excitation du cristal selon un mode utile choisi pour déterminer une référence de fréquence et d'autre part une puissance électrique principale de chauffage interne pour exciter le cristal selon un mode, un partiel ou une vibration anharmonique différents du mode utile choisi pour déterminer une référence de fréquence, la puissance électrique principale de chauffage interne étant régulée à l'aide d'un capteur de température situé sur le résonateur ou au voisinage de celui-ci, afin de maintenir la température du résonateur en permanence au point d'inversion du cristal.

Une telle structure d'oscillateur est décrite par exemple dans la demande de brevet français n° 79 18553 (correspondant à la demande EP 23171 publiée le 28-1-1981) intitulée "oscillateur haute fréquence autothermostaté", et du fait que la puissance électrique de chauffage est appliquée directement sur le résonateur, permet de limiter la dépense d'énergie nécessaire au fonctionnement de l'oscillateur. L'oscillateur peut alors ne plus être équipé que d'un thermostat rudimentaire réglé à une température nettement inférieure à la température d'inversion du cristal du résonateur, par exemple à 50°C si le point d'inversion (PI) du cristal est de 85°C, ou à 35°C si le PI du cristal est de 70°C.

Toutefois, pour que la stabilité de la vibration devant servir de référence de fréquence soit suffisamment importante, il est nécessaire que le défaut d'isochronisme encore dénommé effet amplitude-fréquence ou effet A.F. soit le plus faible possible et que le découplage entre les deux vibrations choisies pour la référence de fréquence et pour le chauffage interne soit le plus important possible.

Ces conditions ne sont pas toujours réalisables en pratique. Ainsi, il est par exemple souvent nécessaire de bâtir un oscillateur autour d'un résonateur dont le cristal est d'une coupe à simple rotation, telle que la coupe AT. En effet, ce type de coupes présente certains avantages qui sont parfois déterminants, tels que leur facilité de fabrication, leur faible coût, leur faible défaut d'hystérésis ou le fait que le point d'inversion de leur caractéristique température-fréquence puisse être élevé (par exemple supérieur à 80°C). Or, un cristal de coupe AT n'est pas particulièrement corrigé en défaut d'isochronisme et le découplage entre les différentes vibrations est mal réalisé.

La présente invention a ainsi pour but de permettre la réalisation d'un oscillateur qui présente les avantages du chauffage interne et de l'autothermostatisation (démarrage rapide, dépense énergétique réduite, utilisation d'un thermostat rudimentaire) et simultanément présente une variation de fréquence, liée aux effets A.F., qui soit réduite au minimum.

La présente invention a encore pour but de permettre l'amélioration des performances aussi bien des oscillateurs utilisant des cristaux à simple rotation (par exemple de coupe AT ou BT) que des oscillateurs utilisant des cristaux à double rotation (par exemple de coupe SC).

Ces buts sont atteints grâce à un oscillateur HF du type mentionné en tête de la description qui, conformément à l'invention, comprend en outre des moyens pour réguler la puissance électrique d'excitation du cristal selon le mode utile dans une proportion prédéterminée et constante par rapport à la puissance électrique principale de chauffage de manière à réaliser, par le défaut d'isochronisme dû à la vibration du cristal selon le mode utile choisi, une compensation de l'effet amplitude-fréquence indirect produit sur la fréquence du mode utile par la vibration destinée à produire le chauffage interne principal.

Du fait que la puissance électrique de chauffage interne appliquée au cristal sur le mode vibratoire de chauffage est régulée par un capteur de température, les variations de cette puissance électrique de chauffage entraînent, par effet amplitude-fréquence indirect, une variation de la fréquence du mode utile de référence de fréquence. Afin de compenser ces variations de fréquence induites et conserver une stabilité de la fréquence du mode utile de référence de fréquence, il est proposé selon la présente invention de réaliser des variations volontaires de la puissance électrique d'excitation du cristal selon le mode utile. Ces variations volontaires de puissance créent par l'effet amplitude-fréquence direct des variations de la fréquence du mode utile de référence de fréquence, lesquelles variations peuvent s'opposer aux variations de fréquence induites par l'effet amplitude-fréquence indirect dû à la présence d'une vibration de chauffage interne. Pour cela, il convient de mettre en oeuvre des moyens pour réaliser une régulation concomitante des puissances électriques d'excitation sur le mode utile et de chauffage interne principal.

Naturellement, pour cela, il convient de connaître, pour un cristal donné, la loi de variation de la fréquence de vibration sur un mode utile en fonction de la puissance électrique appliquée pour provoquer une vibration de chauffage, ainsi que la loi de variation de la fréquence de vibration sur le mode utile en fonction de la puissance électrique appliquée pour provoquer cette vibration.

Ces lois ont été déterminées expérimentalement et sont présentées notamment dans la publication de J.P. Valentin, C.P. Guérin et R.J. Besson intitulée "indirect amplitude-frequency effect in resonators working on two frequencies" et parue dans "Proceedings 35th Annual Frequency Control Symposium" 1981.

Selon un mode particulier de réalisation de l'invention, le cristal piézoélectrique est de coupe AT, est dimensionné et excité pour présenter une fréquence utile de vibration sur le mode partiel 5 ainsi qu'une fréquence de vibration de chauffage interne principal à une fréquence différente de la fréquence utile, sur le mode partiel 3, et la puissance électrique interne totale appliquée aux électrodes du résonateur, régulée en fonction des signaux fournis par ledit capteur de température, est répartie à proportion d'environ 70% sur le mode de vibration partiel 3 et d'environ 30% sur le mode de vibration partiel 5, la répartition de puissance étant effectuée par un réglage préalable des moyens de régulation de l'oscillateur.

Selon un autre mode particulier de réalisation de l'invention, le cristal piézoélectrique est de coupe SC, est dimensionné et excité pour présenter une fréquence utile de vibration sur le mode partiel 3 (mode C) ainsi qu'une fréquence de vibration de chauffage interne sur le mode partiel 3 (mode B), et pour une variation $\Delta P_B$ donnée de la puissance électrique interne appliquée aux électrodes du résonateur sur le mode B, des moyens sont prévus pour faire varier, dans le sens inverse, la puissance électrique appliquée sur le mode C à raison d'environ 28,5% de la variation $\Delta P_B$ de la puissance électrique interne appliquée sur le mode B.

Dans ce cas, le capteur de température comprend avantageusement deux électrodes coopérant avec le cristal piézoélectrique pour produire une vibration du cristal sur le mode B, différente de la vibration utilisée pour le chauffage interne principal, laquelle vibration différente sur le mode B constitue ainsi un mode thermométrique.

De façon plus particulière, les puissances électriques d'excitation sur le mode utile et de chauffage interne principal sont appliquées au moyen de deux boucles d'oscillation distinctes et la puissance électrique d'excitation sur le mode thermométrique est appliquée au résonateur au moyen d'une troisième boucle d'oscillation associée à une paire d'électrodes distinctes de la ou des paires d'électrodes associées aux deux premières boucles d'oscillation, ladite puissance électrique d'excitation sur le mode thermométrique restant négligeable par rapport à la puissance de chauffage interne principal.

L'invention concerne également d'une façon générale un oscillateur HF comprenant, monté dans une enceinte étanche, un résonateur piézoélectrique constitué par au moins un cristal piézoélectrique associé à au moins deux électrodes excitatrices produisant un champ électrique dans la partie active du cristal à partir d'une source d'alimentation régulée dont la tension est susceptible de varier dans le temps, la source d'alimentation fournissant une puissance électrique d'excitation du cristal selon un mode utile choisi pour déterminer une référence de fréquence.

Un tel oscillateur HF est destiné à constituer une référence de fréquence stable mais reste soumis, du fait des variations de tension irréductibles de la source d'alimentation régulée à des fluctuations ou des dérives de fréquence provoquées par le défaut d'isochronisme inhérent à tout cristal.

L'invention vise à améliorer la stabilité d'un oscillateur de ce type et à l'affranchir des variations de tension de la source d'alimentation régulée.

Ceci est possible grâce au fait qu'un oscillateur HF du type précité comprend en outre des moyens pour appliquer au résonateur une fraction prédéterminée de la puissance électrique d'excitation appliquée aux électrodes en relation avec une vibration sur un mode utile, afin de produire une vibration sur un autre mode de vibration prédéterminé du résonateur de manière à réaliser par effet amplitude-fréquence indirect sur la vibration de mode utile une compensation du défaut d'isochronisme dû aux variations de la puissance électrique d'excitation appliquée aux électrodes.

Selon une caractéristique de la présente invention, les puissances électriques d'excitation sur le mode utile, et de compensation par effet amplitude-fréquence indirect sont appliquées au moyen de deux boucles d'oscillation distinctes alimentées à partir d'un même régulateur de tension.

De façon plus particulière, la répartition des puissances électriques appliquées aux deux boucles d'oscillation est réalisée à l'aide d'un pont de résistances associé le cas échéant à un potentiomètre linéaire et interposé entre le régulateur de tension et les boucles d'oscillation.

Le régulateur de tension comprend deux sources d'alimentation et un comparateur.

Dans le cas où le cristal piézoélectrique est de coupe AT, est dimensionné et excité pour présenter une fréquence utile de vibration sur le mode partiel 5 ainsi qu'une fréquence de vibration de compensation sur le mode partiel 3 la puissance électrique interne totale appliquée aux électrodes du résonateur est répartie par les moyens de fractionnement à proportion d'environ 30% sur le mode de vibration partiel 5 et d'environ 70% sur le mode de vibration partiel 3.

Dans le cas où le cristal piézoélectrique est de coupe SC, est dimensionné et excité pour présenter une fréquence utile de vibration sur le mode partiel 3 (mode C) ainsi qu'une fréquence de vibration dc compensation sur le mode partiel 3 (mode B), des moyens sont prévus pour faire varier en sens inverse et de façon simultanée les puissances électriques appliquées sur le mode C, la puissance appliquée sur le mode B variant dans une proportion d'environ 3,5 fois la variation $\Delta P_C$ de la puissance électrique interne appliquée sur le mode C.

D'autres caractéristiques et avantages de l'invention ressortiront de la description qui fait suite de modes particuliers de réalisation de l'invention, donnée en référence aux dessins annexés, sur lesquels:

- la figure 1 représente le schéma électrique d'un oscillateur HF selon l'invention avec une boucle de régulation de la puissance de chauffage du cristal et une boucle de régulation de la puissance électrique appliquée au cristal pour le faire vibrer sur un mode utile de référence de fréquence,

- la figure 2 représente le schéma électrique d'un oscillateur HF analogue à celui de la figure 1 dans lequel le capteur de température est constitué par le cristal lui-même, associé à une boucle d'oscillation supplémentaire, et

- la figure 3 représente le schéma électrique d'un oscillateur HF alimenté par une alimentation stabilisée et comprenant une boucle de compensation de l'influence des variations de la tension de l'alimentation stabilisée.

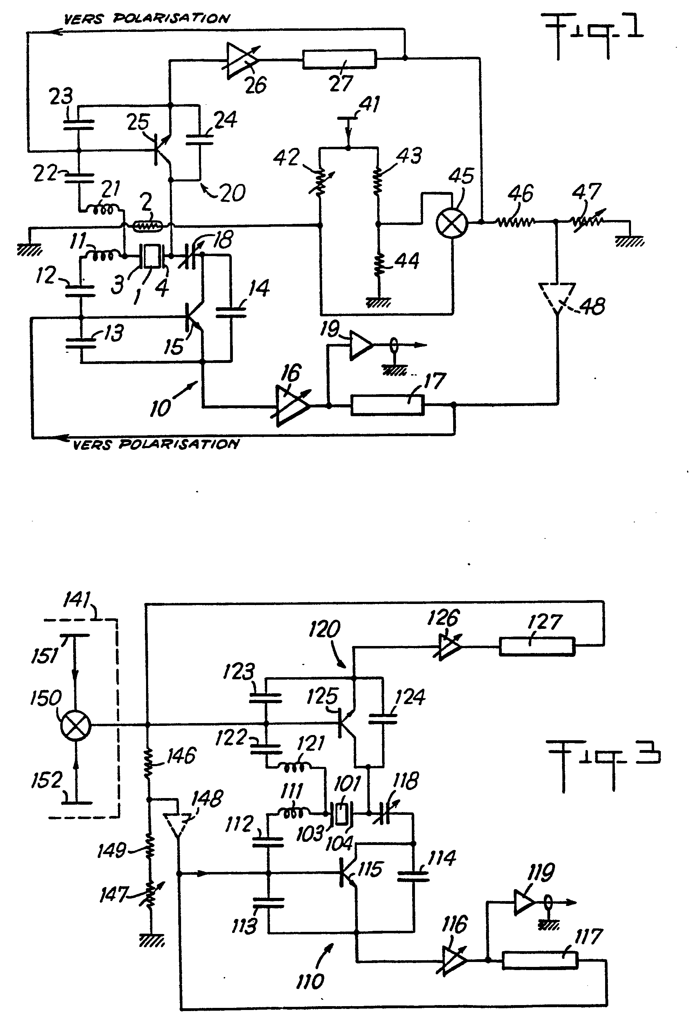

Si l'on se reporte à la figure 1, on voit un oscillateur HF bâti autour d'un résonateur constitué par un cristal piézoélectrique 1 associé à deux électrodes 3,4. Une première boucle d'oscillation 10 comprend, montés en série entre le collecteur et la base d'un transistor 15, un condensateur réglable 18, le résonateur 1,3,4, une inductance 11 et un condensateur de découplage 12. Un condensateur 13 est en outre monté entre la base et l'émetteur du transistor 15 tandis qu'un condensateur 14 est monté entre l'émetteur et le collecteur du transistor 15. L'ensemble des éléments 11 à 15 du résonateur 1,3,4 et du condensateur réglable 18 constitue un circuit sélectif qui, grâce à ce dernier élément réglable, peut être centré de façon très précise sur une fréquence prédéterminée, par exemple 5 MHz. L'émetteur du transistor 15 est relié par un amplificateur 16 à gain variable, suivi d'un amplificateur de puissance 19, à une borne de sortie d'un signal de référence de fréquence. Un circuit de détection 17 est en outre connecté entre la sortie de l'amplificateur 16 et une ligne de polarisation reliée à l'émetteur du transistor 15 pour constituer, avec l'amplificateur 16, un circuit de commande automatique de gain. La puissance initiale de la boucle d'oscillation 10 est réglée par le gain choisi pour l'amplificateur 16.

Une seconde boucle d'oscillation 20 comprend, en série avec le résonateur 1,3,4, une inductance 21 et un condensateur de découplage 22, le circuit série 1,3,4; 21 et 22 étant connecté entre la base et le collecteur d'un transistor 25. Un condensateur 23 est monté entre la base et l'émetteur du transistor 25 tandis qu'un condensateur 24 est monté entre le collecteur et l'émetteur du transistor 25. L'ensemble des éléments 1,3,4; 21 à 25 constitue un circuit sélectif centré sur une fréquence différente de la fréquence du circuit sélectif de la boucle 10. Un circuit de commande automatique de gain comprenant un amplificateur 26 à gain variable et un circuit de détection 27 est connecté entre l'émetteur et la base du transistor 25.

La base du transistor 25 est en outre reliée à un circuit de régulation qui comprend une source de tension d'alimentation de référence 41 reliée à un pont de résistances 2,42,43,44 associé à un comparateur 45. Le pont de résistances comprend deux résistances 43, 44 montées en série entre l'alimentation 41 et la masse, ainsi qu'une résistance ajustable 42 et une thermistance 2 également montées en série entre l'alimentation 41 et la masse. La thermistance 2 est disposée au voisinage du cristal 1 et constitue un capteur de température. Les entrées du comparateur 45 sont reliées aux points communs de connexion entre les résistances 43 et 44 d'une part et entre la résistance ajustable 42 et la thermistance 2 d'autre part, tandis que la sortie du comparateur 45 est connectée à la sortie du circuit de détection 27 et à la base du transistor 25. La résistance ajustable 42 permet d'équilibrer le pont de mesure 42,2,43,44 pour une température prédéterminée, par exemple la température du point d'inversion du cristal de quartz 1. Une variation de température enregistrée par la thermistance 2 se traduit par l'apparition d'une tension à la sortie du comparateur 45. Cette tension est répartie à l'aide du pont de résistances 46, 47 sur les lignes de polarisation des transistors 15,25. La résistance 46 et la résistance ajustable 47 sont montées entre la sortie du comparateur 45 et la masse, le point commun de connexion des résistances 46,47 étant relié à la base du transistor 15. Comme on peut le voir, les variations de la puissance électrique appliquée sur la boucle d'oscillation 10 à partir du point commun de connexion des résistances 46,47 constituent une fraction des variations de la puissance électrique appliquée sur la boucle d'oscillation 20 qui constitue une boucle de régulation en fonction de la température. La puissance initiale de chaque boucle d'oscillation 10,20 est réglée par le gain choisi pour les amplificateurs 16,26. Pour chaque boucle d'oscillation 10,20, le circuit de contrôle automatique de gain 16,17 respectivement 26, 27 amplifie le signal disponible sur l'émetteur du transistor correspondant 15,25 et le détecte, et la tension résultante permet de contrôler la polarisation du transistor correspondant 15,25.

La résistance ajustable 47 permet de régler le rapport de variation de puissance demandée à chaque oscillateur 10, 20 en cas de variation de la température à laquelle doit être maintenu le cristal de quartz 1. Ce rapport est réglé initialement une fois pour toutes.

On relèvera que les condensateurs 12,22 connectés à la base des transistors 15,25 des oscillateurs 10,20 ont simplement pour rôle de découpler les circuits de polarisation de chacun de ces transistors 15,25.

Les circuits de la figure 1 qui correspondent à un fonctionnement du résonateur 1,3,4 sur deux fréquences différentes avec des puissances qui sont contrôlées pour chacune des boucles d'oscillation 10,20 peuvent s'appliquer à des cristaux à simple rotation, par exemple de coupe AT ou BT ou à double rotation, par exemple de coupe SC. Dans ce dernier cas, il convient toutefois d'insérer un circuit inverseur supplémentaire 48 entre le point commun des résistances 46, 47 et la ligne de polarisation du transistor 15 de la boucle d'oscillation 10. En effet, comme cela sera expliqué plus en détail ci-dessous les variations de la fréquence métrologique en fonction de la puissance d'excitation de ce mode métrologique, liées à l'effet A.F. direct, et les variations de cette fréquence liées à l'effet A.F. indirect induit par les variations de la puissance du mode de compensation, sont linéaires et de même sens pour une coupe SC.

Dans le cas du schéma de la figure 1, les deux boucles d'oscillation 10,20 peuvent utiliser le même résonateur 1,3,4 comportant des électrodes communes 3,4. Il est toutefois également possible d'utiliser deux paires d'électrodes différentes pour les deux boucles d'oscillation 10,20 chacune des paires d'électrodes coopérant avec le même cristal 1.

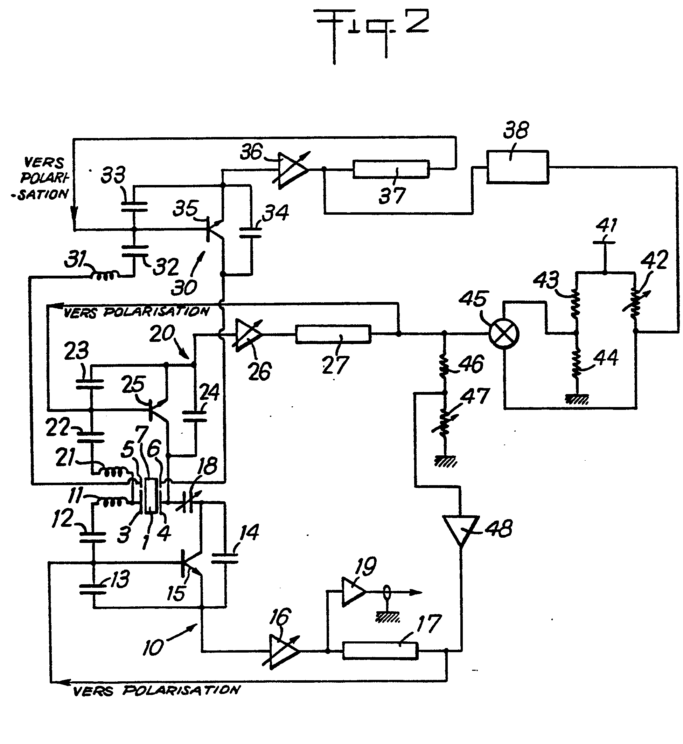

Le schéma de la figure 2 est similaire à celui de la figure 1 mais est plus spécifiquement adapté aux cristaux de coupe SC. Les éléments semblables au circuit de la figure 1 portent les mêmes références sur les figures 1 et 2. On voit ainsi que les deux boucles d'oscillation 10,20 sont tout à fait semblables sur les deux figures. Toutefois, sur la figure 2, le capteur de température n'est pas constitué par une thermistance, mais par une paire d'électrodes 5,6 coopérant avec une partie 7 du cristal 1 pour former un résonateur 5,6,7. Ce résonateur 5,6,7 est incorporé dans une boucle d'oscillation 30 dont les éléments 31 à 37 correspondent respectivement aux éléments 11 à 17 de la boucle d'oscillation 10 ou aux éléments 21 à 27 de la boucle d'oscillation 20. Toutefois, le résonateur 5,6,7 est adapté pour présenter des vibrations sur un mode B particulièrement sensible à la température, et différent du mode B utilisé pour le chauffage interne du cristal et pour la régulation de température au sein de la boucle d'oscillation 20. Par ailleurs, la puissance électrique d'excitation sur le mode B thermométrique, appliquée par la boucle d'oscillation 30, est déterminée de manière à rester négligeable par rapport à la puissance de chauffage interne principal appliquée par la boucle d'oscillation 20.

La sortie de l'amplificateur 36 à gain réglable est appliquée par l'intermédiaire d'un circuit 38 de conversion fréquence-tension à l'extrémité de la résistance ajustable 42 non reliée à l'alimentation 41, de manière à fournir au sein du pont de mesure 42,43, 44,38 un signal qui déséquilibre celui-ci lorsque la température du cristal diffère de la température prédéterminée choisie qui correspond par exemple au point d'inversion. La régulation du chauffage interne par la boucle d'oscillation 20 et la compensation dans la boucle d'oscillation 10 de l'effet amplitude-fréquence indirect produit par la boucle d'oscillation 20 sur la vibration de référence du cristal s'effectuent de la même manière que dans le cas de la figure 1 par le pont diviseut 46, 47.

On décrira maintenant des exemples d'utilisation des circuits des figures 1 et 2.

Avec un circuit du type de celui de la figure 1, il est possible d'utiliser en particulier des cristaux de quartz de coupe AT qui présentent un défaut d'isochronisme relativement grand.

La fréquence métrologique de référence peut par exemple correspondre à la vibration de cisaillement d'épaisseur à 5 MHz en partiel 5, dite 5 MHz P5. La puissance électrique appliquée à cette vibration peut être relativement élevée par exemple de l'ordre de 4mW.

On peut choisir comme deuxième vibration réalisant la plus grande partie du chauffage interne le partiel 3 du mode fondamental à 3 MHz, c'est-à-dire le 3 MHz P3. La puissance électrique appliquée pour cette vibration de chauffage est par exemple de l'ordre de 10 mW. Cette puissance électrique appliquée par la boucle d'oscillation 20 est régulée par le capteur de température 2 situé au niveau du capot de l'oscillateur ou de préférence au niveau du résonateur, par exemple sur la tranche du résonateur ou sur la couronne du résonateur dans le cas d'une suspension monolithique à électrodes non adhérentes au cristal présentant une couronne de support. La régulation de température permet de maintenir la température du résonateur en permanence à une valeur prédéterminée, par exemple celle correspondant à son point d'inversion qui peut être de l'ordre de 85°C.

Les variations de puissance appliquées sur la boucle d'oscillation 20 à 3MHz P3 entraînent, par effet amplitude-fréquence indirect une variation de la fréquence de l'oscillateur 10 à 5MHz P5. Pour une coupe AT, la variation relative de fréquence de la vibration a 5MHz P5 est de l'ordre de quelques $10^{-6}$ par milliwatt de variation de la puissance de l'oscillateur 20 à 3MHz P3.

Par le montage représenté sur la figure 1, la puissance du mode métrologique 5MHz P5 varie d'une manière qui peut compenser, par l'effet amplitude-fréquence direct (ou défaut d'isochronisme), l'effet amplitude-fréquence indirect dû aux variations de la puissance de la vibration de chauffage à 3MHz P3.

Il a été déterminé expérimentalement que la variation de la fréquence métrologique 5MHz P5 en fonction de la puissance de la vibration de chauffage 3MHz P3 (effet A.F. indirect) et la variation de la fréquence métrologique 5MHz P5 en fonction de sa propre puissance (effet A.F. direct) sont linéaires et présentent des pentes de signe différent. Ainsi, pour l'effet AF indirect, on a mesuré une pente $\frac{df}{dP}$ voisine de - 2,5 $10^{-6}$ /mW (en valeur relative), et cette pente ne dépend que très légèrement de la puissance de fonctionnement de l'oscillateur à 5MHz P5. Ainsi, la pente $\frac{df}{dP}$ = -2,7 $10^{-6}$ /mW pour une puissance de 2 $\mu$W appliquée à la vibration 5MHz P5 et la pente $\frac{df}{dP}$ = -2,3 $10^{-6}$/mW pour une puissance de 100 $\mu$W appliquée à la vibration 5MHz P5. Pour l'effet AF direct, on a mesuré une pente de $+5.10^{-6}$/mW, ce qui correspond donc à une pente qui est approximativement le double de celle correspondant à l'effet AF indirect, et de sens inverse, ce qui permet de réaliser une compensation aisée par le simple pont diviseur 46, 47 et sans circuit inverseur 48.

A titre d'exemple, si le point de fonctionnement moyen de l'oscillateur 20 à 3MHz P3 correspond à 10mW, et si le capteur de température 2 enregistre une baisse de la température du cristal 1, le système électronique de compensation qui comprend notamment le comparateur 45 commande le circuit réglant la puissance de la boucle d'oscillation 20 du 3MHz P3 pour augmenter la puissance de 0,1 mW par exemple, entraînant par effet AF indirect une diminution de la fréquence de sortie de la boucle d'oscillation 10 telle que $\frac{\Delta f}{f}$ (5MHz) = 2,3 $10^{-7}$.

Cette variation de fréquence doit être compensée par une augmentation de la puissance de l'oscillateur 10 à 5MHz P5 telle qu'elle entraîne une augmentation de la fréquence de sortie du 5MHz P5 équivalente à la diminution précédente. La puissance de l'oscillateur 10 du 5MHz P5 doit ainsi augmenter de $\frac{2,3 \ 10^{-7}}{5 \ 10^{-6}}$ = 0,046 mW. Globalement, pour obtenir un $\frac{\Delta f}{f}$ = 0 sur le mode métrologique 5MHz P5 il faut répartir la puissance interne de la façon suivante:

$\frac{1}{1,46}$ = 68,5% sur l'oscillateur 20 à 3MHz P3 et $\frac{0,46}{1,46}$ = 31,5% sur l'oscillateur 10 à 5MHz P5.

On a montré (cf. "Internal Heating and Thermal Regulation of Bulk quartz resonators" AFCS 1980) que pour un résonateur très bien isolé thermiquement l'augmentation de température par milliwatt de puissance interne appliquée était d'environ 2,5°C/mW (ou encore l'augmentation de puissance interne appliquée nécessaire par degré de température est: 0,4 mW/°C). Pour un écart de température entre la température du P.I. et la température extérieure de 100°C il faut donc $\neq$ 40mW de puissance interne appliquée sur le cristal de quartz. Le défaut d'isochronisme d'une coupe A.T. est trop important pour que l'on puisse appliquer une telle puissance, il faudra donc nécessairement fonctionner avec un thermostat rudimentaire centré à $\neq$ 50°C. Pour atteindre un point d'inversion de 85°C il suffit alors de (85-50)x 0,4 = 14 mW que l'on peut répartir à environ 70% sur l'oscillateur 20 du 3MHz P3 et 30% sur l'oscillateur 10 du 5MHz P5. Les lois des effets AF et IAF étant linéaires, cette répartition est la même quel que soit le point de fonctionnement du résonateur; la répartition de puissance est ainsi établie une fois pour toutes par un réglage préalable de la résistance 47 de l'oscillateur ainsi compensé.

Il faut noter qu'un cristal de coupe BT peut être utilisé dans des conditions assez proches de celles d'un cristal de la coupe AT pour réaliser un oscillateur à défaut d'isochronisme compensé.

Pour la coupe AT comme pour la coupe BT le fonctionnement décrit est possible dans une large gamme de temperature, typiquement - 40°C à 85°C, ces limites pouvant d'ailleurs être dépassées. Dans cette gamme de température et pour ces deux coupes la stabilite de frequence obtenue peut atteindre quelques $10^{-7}$ en valeur relative, le résonateur étant chauffé par puissance interne et à l'aide d'un thermostat rudimentaire fonctionnant autour de 50°C.

Une autre possibilité de compensation de l'effet A.F. indirect par l'effet A.F. est possible avec des cristaux de coupe SC. En effet, la coupe SC (à double rotation) peut dans certains cas être préférée aux autres coupes traditionnelles et en particulier à la coupe AT pour les raisons suivantes:

- elle est moins sensible à l'accélération.
- elle présente moins d'effet dynamique de température, permettant ainsi une mise en température plus rapide lors de la mise en marche de l'oscillateur
- elle présente un effet A.F. plus faible.
- elle ne présente pas de modes couplés
- la compensation thermique autour du P.I. est meilleure qu'avec un cristal de coupe AT.

Par ailleurs, pour une coupe SC, il existe un mode (dit mode B) très sensible à la température et pouvant de ce fait servir de capteur de température de la partie résonnante, de la manière décrite en référence à la figure 2.

Comme dans le cas de la coupe A.T. l'utilisation du chauffage interne reste limité pour une coupe SC. En effet, le défaut d'isochronisme de cette coupe reste non négligeable, bien qu' environ 7 fois plus faible que pour une coupe AT. On atteint cependant, par chauffage interne, sans thermostat donc avec une importante économie d'énergie, des stabilités de fréquence de quelques $10^{-6}$ en valeur relative sur la gamme -40°C à + 80°C. Les oscillateurs H.F. autothermostatés à coupe SC occupent donc le même créneau que les oscillateurs non thermostatés compensés par thermistances (TCXO) avec l'avantage de ne pas utiliser de diode à capacité variable susceptible d'entraîner une dégradation de la stabilité à court terme et nécessitant d'autre part une référence de tension continue très précise.

Les performances d'un oscillateur HF utilisant un cristal de coupe SC peuvent ainsi être d'un très haut niveau si un montage conforme à l'invention tel que celui de la figure 2 est adopté.

On peut par exemple choisir comme fréquence métrologique le 5MHz P3 (mode C) de la coupe SC et comme fréquence de vibration de chauffage interne le 5,47 MHz P3 (mode B) ou encore le 9,11 MHz P5 (mode B), la fréquence fondamentale en mode C étant ici choisie égale à 1,66 MHz. L'expérience montre que les effets AF (relatif au 5MHz P3) et AF indirect (relatif à l'action du 5,47 MHz P3 (mode B) sur le 5 MHz P3) sont tous deux linéaires et de même sens. Une compensation nécessite donc la présence d'un circuit inverseur 48.

Un exemple de fonctionnement est le suivant: Pour un cristal de coupe SC devant être maintenu à son P.I. situé à 80°C, on applique une puissance de 39 mW sur le mode B (boucle d'oscillation 20) et 1mW sur le mode C (boucle d'oscillation 10) la somme, 40mW, correspond à la possibilité, en chauffage interne et sans thermostat, d'établir une différence de température de 100°C entre le cristal de quartz et la température extérieure à l'oscillateur. La température extérieure est donc ici considérée comme égale à -20°C. Si la température extérieure augmente, il faut diminuer la puissance interne sans entraîner de variation de fréquence notable. Pour une diminution de 1mW de la puissance de l'oscillateur 20 (mode B) (entraînant un $\frac{\Delta f}{f} \approx 2 \cdot 10^{-7}$) il faut compenser par une augmentation d'environ $\frac{2}{7}$ mW de la puissance de l'oscillateur 10 (mode C): en effet, la pente de l'effet AF du 5MHz P3 est $\approx + 2.10^{-7}$/mW. Si l'on applique sur le mode B une puissance à peu près nulle (donc diminution de 39mW) il faut appliquer sur le mode C une puissance égale à 1mW + $\frac{2}{7}$ x 39 = 12,1mW. Cette puissance interne correspond à une différence de température entre le cristal de quartz et l'extérieur de 2,5 x 12,1 soit $\approx 30°$C. Le quartz étant maintenu à son PI (80°C), la température extérieure est alors $\approx 50°$C. La gamme de température pour laquelle le système fonctionne est donc: - 20°C à + 50°C, sans thermostat, et avec une puissance interne maximum de 40mW. Dans ces conditions, le cristal de quartz reste à son P.I. à 80°C. Avec le seul chauffage interne de la boucle d'oscillateur 20, sans thermostat et sans compensation de l'effet AF par l'effet IAF, la stabilité de fréquence d'un résonateur isolé de coupe SC est de quelques $10^{-6}$ sur la gamme considérée: - 20°C à + 50°C. Dans les mêmes conditions mais avec la compensation due à la présence des éléments 46, 47, 48, la stabilité de fréquence est améliorée d'un facteur 20 environ et devient donc $\approx 1.10^{-7}$.

Enfin, dans ce type de fonctionnement, les modes B étant très sensibles à la température (environ - 170Hz/1°C), l'un d'entre eux (par exemple 5,47 MHz P3) peut être utilisé comme capteur de la température du résonateur (boucle d'oscillation 30),tandis que l'autre mode B (9,11 MHz P5) est utilisé pour le chauffage.

Dans ce cas, la puissance de la boucle d'oscillation 30 reste négligeable par rapport à celle de la boucle d'oscillation 20 et ne produit pas d'effet AF indirect sensible sur la fréquence métrologique de la boucle d'oscillation 10. La puissance de la boucle d'oscillation 30 peut être par exemple de l'ordre de quelques dizaines de microwatts lorsque la puissance de la boucle d'oscillation 20 est de l'ordre de plusieurs milliwatts.

Le circuit de la figure 3 montre un oscillateur à quartz à défaut d'isochronisme compensé comprenant deux boucles d'oscillation 110 et 120 coopérant avec un résonateur constitué par un cristal de quartz 101 associé à deux électrodes 103, 104.

Les éléments 111 à 119 de la boucle d'oscillation 110 et les éléments 121 à 127 de la boucle d'oscillation 120 correspondent respectivement aux éléments 11 à 19 de la boucle d'oscillation 10 et aux éléments 21 à 29 de la boucle d'oscillation 20 des circuits des figures 1 et 2, et ne seront donc pas décrits en détail. Toutefois, dans le cas du circuit de la figure 3, il n'est pas prévu de régulation de la température du cristal 101 au niveau du résonateur 101,103,104. Le résonateur, qui n'est pas autothermostaté, est simplement placé de façon classique dans un thermostat extérieur possédant sa propre régulation et non représenté sur la fig. 3. Les deux boucles d'oscillation 110,120 qui permettent au cristal 101 de vibrer sur un premier mode de référence de fréquence (boucle 110) et sur un second mode de compensation (boucle 120) n'ont donc pas de rôle de régulation de température et contribuent à réduire le défaut d'isochronisme, ou effet AF dû à des variations de la tension d'alimentation de l'oscillateur.

Comme cela a été rappelé précédemment, le défaut d'isochronisme ou effet AF (amplitude-fréquence) correspond à une variation de fréquence de l'oscillateur liée à une variation de l'amplitude des oscillations, elle-même liée à une variation de la puissance d'excitation du résonateur, cette variation de puissance d'excitation pouvant provenir notamment de fluctuations ou de dérives de la source d'alimentation de l'oscillateur. En effet, même en présence d'une régulation de la tension d'alimentation, les oscillateurs HF à quartz de haute stabilité restent sensibles aux fluctuations ou dérives résiduelles de la tension d'alimentation.

Le défaut d'isochronisme peut être diminué par le choix d'un cristal taillé de façon particulière par rapport au repère cristallographique, mais les coupes à faible défaut d'isochronisme présentent généralement d'autres inconvénients, tels que des propriétés thermiques peu intéressantes.

Ainsi, il est en général souhaitable d'utiliser pour un oscillateur HF de haute stabilité un cristal de quartz de coupe AT dont le défaut d'isochronisme pour une vibration 5MHz P5 reste tel que la variation relative de fréquence $\frac{\Delta f}{f}$ en fonction de la puissance d'excitation est proche de $5.10^{-6}$/mW.

La compensation de ce défaut d'isochronisme peut être réalisée de façon automatique et permanente avec le circuit de la figure 3 où le résonateur 101, 103, 104 fonctionne simultanément sur deux fréquences. La première fréquence correspond au mode normal de fonctionnement du résonateur et constitue le mode métrologique qui délivre la fréquence très stable et se trouve produit par la boucle d'oscillation 110. Pour un oscillateur 5MHz utilisant une coupe AT, ce mode peut être le partiel 5 pour une vibration en cisaillement d'épaisseur.

La seconde fréquence produite par la boucle d'excitation 120 correspond par exemple dans le cas de la coupe AT au partiel 3, donc à une fréquence sensiblement égale à 3MHz.

Les circuits électroniques des boucles d'oscillation 110, 120 sont alimentés à partir du même régulateur de tension 141, de façon que les variations de tension du régulateur induisent des variations de puissance proportionnelles sur les deux boucles d'oscillation 110, 120. Ceci peut être obtenu par un simple pont de résistances disposé entre le régulateur de tension 141 et les boucles d'oscillation 110, 120. Dans le cas d'un cristal de coupe AT, l'effet AF direct du mode 5MHz P5 et l'effet AF indirect du mode 3MHz P3 sur le mode 5MHz P5 sont linéaires en fonction de la puissance et les pentes des courbes représentant les variations relatives de fréquence en fonction de la puissance sont de signe opposé et respectivement de l'ordre de $5.10^{-6}$/mW et $- 2,5$ $10^{-6}$/mW de sorte que la compensation du défaut d'isochronisme s'effectue automatiquement si toute variation de la tension du régulateur d'alimentation 141 des deux boucles d'oscillation 110, 120 est représentée sensiblement dans la proportion de 1 à 2 respectivement sur le circuit métrologique 110 et sur le circuit de compensation 120.

Comme on le voit sur la figure 3, le régulateur de tension 141 peut comprendre deux sources d'alimentation 151, 152 qui sont associées aux boucles d'oscillation 110 et 120 et dont les tensions sont comparées en permanence au moyen d'un comparateur 150 qui est initialement réglé à zéro. En cas de variation de l'une ou l'autre des tensions d'alimentation des sources 151 et 152, une tension d'erreur apparait à la sortie du comparateur 150. Cette tension d'erreur est répercutée d'une part directement sur la ligne de polarisation du circuit de compensation 120 et d'autre part par l'intermédiaire du pont diviseur 146, 149, 147 sur la ligne de polarisation du circuit métrologique 110. La tension d'erreur en sortie du comparateur 150 est ainsi répercutée sur les circuits de polarisation des boucles d'oscillation 110, 120 suivant une proportion indépendante du niveau d'oscillation de chaque oscillateur et réglée à l'avance par le choix des valeurs des résistances 146, 149 et du potentiomètre linéaire de réglage fin 147, en fonction des caractéristiques des effets AF direct et AF indirect liés aux modes de vibration choisis pour le cristal 101, de manière que la variation de fréquence du mode métrologique reste nulle.

Dans le cas où les effets AF direct et AF indirect relatifs aux deux modes de vibration choisis pour le cristal 101 se traduisent par des courbes de variations relatives de fréquence en fonction de la puissance dont les pentes sont de même signe, comme c'est le cas par exemple pour des vibrations sur le mode C et le mode B d'une coupe SC, il suffit de modifier le circuit de la figure 3 par l'adjonction d'un circuit inverseur 148 (représenté en pointillés) entre le point milieu du pont diviseur 146, 149, 147 et la ligne de polarisation de la boucle d'oscillation 110.

On notera que la réalisation d'un oscillateur à effet d'isochronisme compensé tel que celui représenté sur la figure 3 peut fonctionner à des niveaux de puissance relativement élevés, ce qui conduit à un rapport signal/bruit élevé, et donc à une grande pureté spectrale. La puissance de fonctionnement du mode métrologique peut par exemple être choisie pour correspondre à un vieillissement nul (soit 80 μW pour un cristal naturel, coupe AT, 5MHz P5).

## Revendications

1. Oscillateur haute fréquence du type comprenant, monté dans une enceinte étanche, un résonateur piézoélectrique constitué par au moins un cristal piézoélectrique (1) associé à au moins deux électrodes excitatrices (3, 4) produisant un champ électrique dans la partie active du cristal piézoélectrique (1), des moyens pour appliquer aux électrodes (3, 4) d'une part une puissance électrique d'excitation du cristal selon un mode utile choisi pour déterminer une référence de fréquence et d'autre part une puissance électrique principale de chauffage interne pour exciter le cristal selon un mode, un partiel ou une vibration anharmonique différents du mode utile choisi pour déterminer une référence de fréquence, la puissance électrique principale de chauffage interne étant régulée à l'aide d'un capteur de température (2, 7) situé sur le résonateur ou au voisinage de celui-ci, afin de maintenir la température du résonateur en permanence au point d'inversion du cristal, caractérisé en ce qu'il comprend en outre des moyens (46, 47) pour réguler la puissance électrique d'excitation du cristal selon le mode utile dans une proportion prédéterminée et constante par rapport à la puissance électrique principale de chauffage de manière à réaliser, par le défaut d'isochronisme dû à la vibration du cristal selon le mode utile choisi, une compensation de l'effet amplitude-fréquence indirect produit sur la fréquence du mode utile par la vibration destinée à produire le chauffage interne principal.

2. Oscillateur selon la revendication 1, caractérisé en ce qu'il est disposé dans un thermostat rudimentaire fonctionnant autour d'une valeur voisine de 50°C.

3. Oscillateur selon la revendication 1 ou la revendication 2, caractérisé en ce que le cristal piézoélectrique (1) est de coupe AT, est dimensionné et excité pour présenter une fréquence utile de vibration sur le mode partiel 5 ainsi qu'une fréquence de vibration de chauffage interne principal à une fréquence différente de la fréquence utile, sur le mode partiel 3, et en ce que la puissance électrique interne totale appliquée aux électrodes (3, 4) du résonateur, régulée en fonction des signaux fournis par ledit capteur de température (2, 7), est répartie à proportion d'environ 70% sur le mode de vibration partiel 3 et d'environ 30% sur le mode de vibration partiel 5, la répartition de puissance étant effectuée par un réglage préalable des moyens (46, 47) de régulation de l'oscillateur.

4. Oscillateur selon la revendication 1 ou la revendication 2, caractérisé en ce que le cristal piézoélectrique (1) est de coupe SC, est dimensionné et excité pour présenter une fréquence utile de vibration sur le mode partiel 3 (mode C) ainsi qu'une fréquence de vibration de chauffage interne sur le mode partiel 3 (mode B), et en ce que pour une variation $\Delta P_B$ donnée de la puissance électrique interne appliquée aux électrodes du résonateur sur le mode B, des moyens (46, 47, 48) sont prévus pour faire varier, dans le sens inverse, la puissance électrique appliquée sur le mode C à raison d'environ 28,5% de la variation $\Delta P_B$ de la puissance électrique interne appliquée sur le mode B.

5. Oscillateur selon la revendication 4, caractérisé en ce que le capteur de température (7) comprend deux électrodes (5,6) coopérant avec le cristal piézoélectrique (1) pour produire une vibration du cristal sur le mode B, différente de la vibration utilisée pour le chauffage interne principal, laquelle vibration différente sur le mode B constitue ainsi un mode thermométrique.

6. Oscillateur selon la revendication 5, caractérisé en ce que les puissances électriques d'excitation sur le mode utile et de chauffage interne principal sont appliquées au moyen de deux boucles d'oscillation distinctes (10, 20) et en ce que la puissance électrique d'excitation sur le mode thermométrique est appliquée au résonateur au moyen d'une troisième boucle d'oscillation (30) associée à une paire d'électrodes (5, 6) distinctes de la ou des paires d'électrodes (3, 4) associées aux deux premières boucles d'oscillation (10, 20), ladite puissance électrique d'excitation sur le mode thermométrique restant négligeable par rapport à la puissance de chauffage interne principal.

7. Oscillateur haute fréquence comprenant, monté dans une enceinte étanche, un résonateur piézoélectrique constitué par au moins un cristal piézoélectrique (101) associé à au moins deux électrodes excitatrices (103, 104) produisant un champ électrique dans la partie active du cristal (101) à partir d'une source d'alimentation régulée (141) dont la tension est susceptible de varier dans le temps, la source d'alimentation (141) fournissant une puissance électrique d'excitation du cristal selon un mode utile choisi pour déterminer une référence de fréquence, caractérisé en ce qu'il comprend des moyens (146, 147, 149) pour appliquer au résonateur (101, 103, 104) une fraction prédéterminée de la puissance électrique d'excitation appliquée aux électrodes en relation avec une vibration sur un mode utile, afin de produire une vibration sur un autre mode de vibration prédéterminé du résonateur de manière à réaliser par effet amplitude-fréquence indirect sur la vibration de mode utile une compensation du défaut d'isochronisme dû aux variations de la puissance électrique d'excitation appliquée aux électrodes.

8. Oscillateur selon la revendication 7, caractérisé en ce que les puissances électriques d'excitation sur le mode utile, et de compensation par effet amplitude-fréquence indirect sont appliquées au moyen de deux boucles d'oscillation distinctes (110, 120) alimentées à partir d'un même régulateur de tension (141).

9. Oscillateur selon la revendication 8, caractérisé en ce que la répartition des puissances électriques appliquées aux deux boucles d'oscillation (110, 120) est réalisée à l'aide d'un pont de résistances (146, 149) associé le cas échéant à un potentiomètre linéaire (147) et interposé entre le régulateur de tension (141) et les boucles d'oscillation (110, 120).

10. Oscillateur selon l'une quelconque des revendications 7 à 9, caractérisé en ce que le régulateur de tension (141) comprend deux sources d'alimentation (151, 152) et un comparateur (150).

11. Oscillateur selon l'une quelconque des revendications 7 à 10, caractérisé en ce que le cristal piézoélectrique (101) est de coupe AT, est dimensionné et excité pour présenter une fréquence utile de vibration sur le mode partiel 5 ainsi qu'une fréquence de vibration de compensation sur la mode partiel 3 et en ce que la puissance électrique interne totale appliquée aux électrodes (103, 104) du résonateur est répartie par les moyens de fractionnement (146, 147) à proportion d'environ 30% sur le mode de vibration partiel 5 et d'environ 70% sur le mode de vibration partiel 3.

12. Oscillateur selon l'une quelconque des revendications 8 à 10, caractérisé en ce que le cristal piézoélectrique (101) est de coupe SC. est dimensionné et excité pour présenter une fréquence utile de vibration sur le mode partiel 3 (mode C) ainsi qu'une fréquence de vibration de compensation sur le mode partiel 3 (mode B) et en ce que des moyens (146, 147, 149, 148) sont prévus pour faire varier en sens inverse et de façon simultanée les puissances électriques appliquées sur le mode B ou sur le mode C, la puissance appliquée sur le mode B variant dans une proportion d'environ 3,5 fois la variation $\Delta P_C$ de la puissance électrique interne appliquée sur le mode C.

**Patentansprüche**

1. - Hochfrequenz-Oszillator eines Types bestehend aus einem, in einem dichten Gehäuse eingebauten piezoelektrischen Resonator, selber bestehend aus mindestens einem piezoelektrischen Kristall (1) mit mindestens zwei mitgekoppelten Erregungselektroden (3, 4), die im aktiven Teil des piezoelektrischen Kristalls (1) ein elektrisches Feld erzeugen, sowie aus entsprechenden Mitteln zur Beaufschlagung der Elektroden (3, 4) mit einer elektrischen Leistung zur Erregung des Kristalls nach einem geeigneten zur Festlegung einer Bezugsfrequenz gewählten Feldtyp einerseits und mit einer elektrischen Hauptleistung für die innere Heizung zur Erregung des Kristalls nach einer Art, einer Teilschwingungsform oder einer unharmonischen Schwingung, die vom zur Erzielung der Bezugsfrequenz gewählten Feldtyp abweicht, andererseits, wobei die elektrische Hauptleistung zur inneren Heizung über einen auf dem Resonator oder in unmittelbarer Nähe angebrachten Temperaturfühler (2, 7) geregelt wird, um die Temperatur des Resonators stetig am Umwandlungspunkt des Kristalls zu halten, dadurch gekennzeichnet, daß er ausserdem Mittel (46, 47) zur Regelung der elektrischen Erregungsleistung nach einem geeigneten Feldtyp in einem vorermittelten und unveränderlichen Verhältnis zur elektrischen Heizhauptleistung aufweist, um durch den aus der Kristallschwingung nach der gewählten geeigneten Erregungsform entstehenden Ungleichzeitigkeitsfehler einen Ausgleich des indirekten Amplitude-Frequenz-Effektes zu erzielen, der die Frequenz der Nutz-Schwingungsform durch die Schwingung zur Erzeugung der inneren Heizungshauptleistung beeinflußt.

2. - Oszillator nach Anspruch 1, dadurch gekennzeichnet, daß er in einem einfachen Temperaturregler eingebaut ist, der um einen Wert von 50°C arbeitet.

3. - Oszillator nach Anspruch 1 oder Anspruch 2, dadurch gekennzeichnet, daß der piezoelektrische Kristall (1) eine AT-Orientierung aufweist, und entsprechend ausgelegt ist und erregt wird, um eine geeignete Schwingfrequenz in der Teilschwingungsform 5 sowie eine Schwingfrequenz zur Erzeugung der inneren Hauptheizungsleistung, die von der geeigneten Schwingfrequenz der Teilschwingungsform 3 abweicht, zu erzielen, und daß die gesamte innere elektrische Leistung, mit der die Elektroden (3, 4) des Resonators beaufschlagt werden und die mittels der aus dem bereits erwähnten Temperaturfühler (2, 7) stammenden Steuersignale einreguliert wird, im Verhältnis von ca. 70 % nach Teilschwingungsform 3 und ca. 30 % nach Teilschwingungsform 5 verteilt wird, wobei die Leistungsverteilung durch eine vorläufige Einstellung der Regelmittel (46, 47) des Oszillators erfolgt.

4. - Oszillator nach Anspruch 1 oder Anspruch 2, dadurch gekennzeichnet, daß der piezoelektrische Kristall (1) eine SC-Orientierung aufweist, und entsprechend ausgelegt ist und erregt wird, um eine geeignete Schwingfrequenz in der Teilschwingungsform 3 (Form C) sowie eine Schwingfrequenz zur Erzeugung der inneren Heizungsleistung in der Teilschwingungsform 3 (Form B) zu erzielen, und daß für eine gegebene Veränderung $\Delta P_B$ der inneren elektrischen Leistung, mit der die Elektroden des Resonators in der Form B beaufschlagt werden, entsprechende Mittel (46, 47, 48) vorgesehen sind, zur Erzeugung einer Veränderung in gegenseitiger Richtung der in der Form C beaufschlagten elektrischen Leistung, die etwa 28,5 % der Veränderung $\Delta P_B$ der in der Form B beaufschlagten inneren elektrischen Leistung entspricht.

5. - Oszillator nach Anspruch 4, dadurch gekennzeichnet, daß der Temperaturfühler (7) zwei Elektroden (5, 6) auf weist, die mit dem piezoelektrischen Kristall (1) mitwirken, um eine Schwingung des Kristalls in der Form B zu erzeugen, die von der zur inneren Hauptheizungsleistung erzeugten Schwingung abweicht, wobei die abweichende Schwingung der Form B folglich einer Temperaturmeßform entspricht.

6. - Oszillator nach Anspruch 5, dadurch gekennzeichnet, daß die elektrischen Erregungsleistungen in der Nutz-Schwingungsform und der inneren Hauptheizungsleistung über zwei getrennte Schwingungsschleifen (10, 20) beaufschlagt werden und daß die elektrische Erregungsleistung in der Temperaturmeßform dem Resonator über eine dritte Schwingungsschleife (30) übertragen wird, die mit einem Elektrodenpaar (5, 6) versehen ist, die von den mit den beiden ersten Schwingungsschleifen (10, 20) mitwirkenden Elektrodenpaaren (3, 4) getrennt sind, wobei die elektrische Erregungsleistung in der Temperaturmeßform gegenüber die innere Hauptheizungsleistung vernachlässigbar ist.

7. - Hochfrequenz-Oszillator bestehend aus einem, in einem dichten Gehäuse eingebauten piezoelektrischen Resonator, selber bestehend aus mindestens einem piezoelektrischen Kristall (101) mit mindestens zwei mitgekoppelten Erregungselektroden (103, 104), die im aktiven Teil des piezoelektrischen Kristalls (101) mittels einer regulierten Stromversorgung (141), deren Ausgangsspannung zeitlich verändert werden kann, ein elektrisches Feld erzeugen, wobei die Spannungsversorgung (141) eine elektrische Erregungsspannung für den Kristall in einer Nutz-Schwingungsform zur Erzielung einer bestimmten Bezugsfrequenz abgibt, dadurch gekennzeichnet, daß er mit Mitteln (146, 147, 149) versehen ist, die für die Beaufschlagung des Resonators (101, 103, 104) mit einem festgelegten Anteil der elektrischen Erregungsleistung zur Erzeugung der Nutz-Schwingungsform vorgesehen sind, damit eine Schwingung in einer anderen festgelegten Schwingungsform des Resonators erzeugt werden kann, um durch einen indirekten Amplituden-Frequenzeffekt auf der Nutz-Schwingungsform einen Ausgleich des Ungleichzeitigkeitsfehlers zu bewirken, der den Änderungen der den Elektroden zugeführten elektrischen Erregungsleistung zurückzuführen ist.

8. - Oszillator nach Anspruch 7, dadurch gekennzeichnet, daß die elektrischen Erregungsleistungen in der Nutzschwingungsform sowie zur Ausgleichung durch indirekten Amplituden-Frequenzeffekt über zwei getrennte Schwingungsschleifen (110, 120) aufgedrückt werden, die vom selben Spannungsregler (141) gespiesen werden.

9. - Oszillator nach Anspruch 8, dadurch gekennzeichnet, daß die Verteilung der den beiden Schwingungsschleifen (110, 120) aufgedrückten elektrischen Leistungen über eine Widerstandsbrücke (146, 149) erfolgt, die ggfs mit einem linearen Potentiometer (147) mitwirkt und zwischen dem Spannungsregler (141) und den Schwingungsschleifen (110, 120) eingeschaltet wird.

10. - Oszillator nach einem beliebigen Anspruch 7 bis 9, dadurch gekennzeichnet, daß der Spannungsregler (141) aus zwei Spannungsquellen (151, 152) und einem Vergleicher (150) besteht.

11. - Oszillator nach einem beliebigen Anspruch 7 bis 10, dadurch gekennzeichnet, daß der piezoelektrische Kristall (101) eine AT-Orientierung aufweist, und entsprechend ausgelegt ist und erregt wird, um eine geeignete Schwingfrequenz in der Teilschwingungsform 5 sowie eine Ausgleich-Schwingfrequenz der Teilschwingungsform 3 zu erzielen, und daß die gesamte innere elektrische Leistung, mit der die Elektroden (103, 104) des Resonators beaufschlagt werden, im Verhältnis von ca. 30 % nach Teilschwingungsform 5 und ca. 70 % nach Teilschwingungsform 3 durch die Verteilungsglieder (146, 147) verteilt wird.

12. - Oszillator nach einem beliebigen Anspruch 8 bis 10, dadurch gekennzeichnet, daß der piezoelektrische Kristall (101) eine SC-Orientierung aufweist, und entsprechend ausgelegt ist und erregt wird, um eine geeignete Schwingfrequenz in der Teilschwingungsform 3 (Form C) sowie eine Ausgleich-Schwingfrequenz in der Teilschwingungsform 3 (Form B) zu erzielen, und daß entsprechende Mittel (146, 147, 149, 148) vorgesehen sind, um eine gleichzeitige Veränderung in gegenseitiger Richtung der in der Form B oder Form C beaufschlagten elektrischen Leistung zu bewirken, wobei die in der Form B beaufschlagten Leistung in einem Verhältnis von 3,5:1 mit der Veränderung $\Delta$ $P_C$ der in der Form C beaufschlagten inneren elektrischen Leistung steht.

**Claims**

1 - High frequency oscillator of the type including, in a sealed enclosure, a piezoelectric resonator consisting of at least one piezoelectric crystal (1) associated with at least two exciter electrodes (3, 4) producing an electric field in the active part of the piezoelectric crystal (1), means for applying to the electrodes (3, 4) an electric power to excite the crystal in a useful mode chosen to determine a frequency reference, and a main electrical power for internal heating to excite the crystal in a mode, a partial mode or an harmonic vibration other than the useful mode chosen to determine a frequency reference, the main electrical power for internal heating being regulated by a temperature transducer (2, 7) on the resonator or in its vicinity, to maintain the resonator temperature continually at the crystal inversion point, wherein it also includes means (46, 47) for regulating the electrical power for exciting the crystal in a useful mode in a predetermined and constant proportion with respect to the main electrical heating current so that, if a defect in isochronism appears due to the vibration of the crystal in the chosen useful mode, a compensation for the indirect amplitude-frequency effect pproduced on the useful mode · frequency by the vibration designed to produce the main internal heating.

2 - Oscillator as claimed in claim 1, wherein it is arranged in a rudimentary thermostat operating about a value close to 50° C.

3 - Oscillator claimed in either claim 1 or 2, wherein the piezoelectric crystal (1) is an AT-cut crystal, with dimensions and excitation to exhibit a useful vibration frequency in partial mode 5 and a main internal heating vibration frequency different from the useful frequency in partial mode 3, and wherein the total internal electrical power applied to the resonator electrodes (3, 4), regulated as a function of the signals output by the said temperature transducer (2, 7), is apportionned approximately 70 % to partial vibration mode 3 and approximately 30 % to partial vibration mode 5, the power being distributed by presetting the oscillator regulation means (46, 47).

4 - Oscillator claimed in either claim 1 or 2, wherein the piezoelectric crystal (1) is an SC-cut crystal, with dimensions and excitation to exhibit a useful vibration frequency in partial mode 3 (mode C) and a main internal heating vibration frequency in partial mode 3 (mode B), and wherein for a given variation $\Delta$ $P_B$ in the internal electric power applied to the resonator electrodes in mode B, means (46, 47, 48) are provided to vary inversely the electrical power applied in mode C by approximately 28,5 % of the variation $\Delta$ $P_B$ of the internal electrical power applied in mode B.

5 - Oscillator claimed in claim 4, wherein the temperature transducer (7) includes two electrodes (5, 6) cooperating with the piezoelectric crystal (1) to produce a crystal vibration in mode B different from the vibration used for the main internal heating, which different vibration in mode B thus constitutes a thermometric mode.

6 - Oscillator claimed in claim 5, wherein the electrical powers for excitation in the useful mode and for main internal heating are applied through two distinct oscillator loops (10, 20) and wherein the electrical excitation power in the thermometric mode is applied to the resonator through a third oscillation loop (30) associated with a pair of electrodes (5, 6) distinct from the pair or pairs of electrodes (3, 4) associated with the first two oscillation loops (10, 20), the said electrical excitation power on the thermometric mode remaining negligible compared with the main internal heating power.

7 - High frequency oscillator of the type including, in a sealed enclosure, a piezoelectric resonator consisting of at least one piezoelectric crystal (101) associated with at least two exciter electrodes (103, 104) producing an electric field in the active part of the piezoelectric crystal (101) from a regulated power supply source (141), the voltage of which can vary in time, the power supply source providing an electrical excitation power to the crystal in a useful mode chosen to determine a frequency reference, wherein it includes means (146, 147, 149) for applying to the resonator (101, 103, 104) a predetermined fraction of the electrical excitation power applied to the electrodes in relation with a vibration in a useful mode, to produce a vibration in another predetermined vibration mode of the resonator so as to create by indirect amplitude-frequency effect on the useful mode vibration a compensation of the isochronism defect due to the variations of the electrical excitation power applied to the electrodes.

8 - Oscillator claimed in claim 7, wherein the electrical powers for excitation in the useful mode and for indirect amplitude-frequency effect compensation are applied through two distinct (110, 120) oscillation loops supplied from the same voltage regulator (141).

9 - Oscillator claimed in claim 8, wherein the electrical powers applied to the two oscillation loops (110, 120) are distributed by a resistance bridge (146, 149) possibly associated with a linear potentiometer (147) and placed in the circuit between the voltage regulator (141) and the oscillation loops (110, 120).

10 - Oscillator claimed in any one of the claims 7 to 9, wherein the voltage regulator (141) includes two power supply sources (151, 152) and one comparator (150).

11 - Oscillator claimed in any one of the claims 7 to 10, wherein the piezoelectric crystal (101) is an AT-cut crystal with dimensions and excitation to exhibit a useful vibration frequency in partial mode 5 and a compensation vibration frequency in partial mode 3 and wherein the total internal electrical power applied to the resonator electrodes (103, 104) is distributed by the apportioning means (146, 147) in a proportion of approximately 30 % to partial vibration mode 5 and approximately 70 % to partial vibration mode 3.

12 - Oscillator claimed in any one claim 8 to 10, wherein the piezoelectric (101) crystal is SC-cut with dimensions and excitation to exhibit a useful vibration frequency in partial mode 3 (mode C) and a compensation vibration frequency in partial mode 3 (mode B) and wherein means (146, 147, 149, 148) are provided to vary inversely and simultaneously the electrical powers applied to mode B or to mode C, the power applied in mode B varying in a proportion of approximately 3.5 times the variation $\Delta P_C$ of the internal electrical power applied to mode C.

0 113 264

VERS POLARISATION

Fig.1

VERS POLARISATION

Fig.3

1

Fig. 2